Europäisches Patentamt

European Patent Office

Office européen des brevets

(19)

(11) Veröffentlichungsnummer: **0 328 644**

**A1**

(12) **EUROPÄISCHE PATENTANMELDUNG**
veröffentlicht nach Art. 158 Abs. 3
EPÜ

(21) Anmeldenummer: **87908015.8**

(22) Anmeldetag: **25.08.87**

(86) Internationale Anmeldenummer:
**PCT/SU87/00093**

(87) Internationale Veröffentlichungsnummer:
**WO 89/02194 (09.03.89 89/06)**

(51) Int. Cl.4: **H03M 1/82**

(43) Veröffentlichungstag der Anmeldung:
**23.08.89 Patentblatt 89/34**

(84) Benannte Vertragsstaaten:
**BE DE FR GB IT**

(71) Anmelder: **BELORUSSKY GOSUDARSTVENNY
UNIVERSITET IMENI V.I.LENINA**
**Leninsky pr., 4**
**Minsk, 220080(SU)**

(72) Erfinder: **MIKHALEV, Alexandr Sergeevich**
**ul. Kuznechnaya, 3-92**
**Minsk, 220039(SU)**

Erfinder: **SIDORENKO, Vladimir Porfirievich**
**ul. Olega Koshevogo, 18-31**
**Minsk, 220009(SU)**
Erfinder: **SIDORUK, Sergei Nikolaevich**
**ul. Kurchatova, 6-814**
**Minsk, 220106(SU)**
Erfinder: **CHUSHENKOV, Igor Mikhailovich**
**Partizansky pr., 74-25**
**Minsk, 220021(SU)**

(74) Vertreter: **Nix, Frank Arnold, Dr.**
**Kröckelbergstrasse 15**
**D-6200 Wiesbaden(DE)**

(54) **KODE-NACH-PULSDAUER-UMSETZER.**

(57) Kode-Impulsdauer-Wandler, der zwei Register (1,2) aufweist, deren Schreibeingänge (3,4) an eine Schiene (5) "Start" und deren Ausgänge ($6_1...6_n$, $7_1...7_p$) an die Kodeeingabeeingänge ($8_1...8_n$, $9_1...9_p$) eines Impulsdauerformers (10) bzw. eines gesteuerten Frequenzteilers (12) gelegt sind. Im Impulsdauer-Former (10) ist ein Zählsignalschalter (22) mit seinen Ausgängen an die Zähleingänge (23, 24) eines Reversierzählers (21) angeschlossen, dessen Überlaufausgänge (34, 35) an die Sperreingänge (30, 31) des Zählsignalschalters (22) geführt sind, dessen Eingang (33) zur Polaritätseinstellung an den Informationseingang ($36_n$) der höchstwertigen Stelle des Reversierzählers (21) gelegt ist. An die Ausgänge (17, 18) des Impulsdauer-Formers (10) sind die Eingänge eines Ausgangssignalschalters (19) angeschlossen, dessen Steuereingang (20) an den Ausgang ($6_n$) der höchstwertigen Stelle des einen Registers (1) angeschlossen ist, und an den Zähleingang (13) des gesteuerten Frequenzteilers (10) ist ein Impulsgenerator (16) angeschlossen.

FIG.1

## KODE-IMPULSDAUER-WANDLER

### Gebiet der Technik

Die vorliegende Erfindung bezieht sich auf die Automatik und Impulstechnik und betrifft insbesondere einen Kode-Impulsdauer-Wandler.

### Bisheriger Stand der Technik

Bei der Impulsbreitensteuerung der Spannung an den Wicklungen von Stromrichterantrieben der genannten Steilwerke ist es notwendig, die Amplitude der Sinusspannung an den Wicklungen des Elektromotors zu regeln, was in der Praxis einer Umwandlung von alternierenden Kodes einer Steuerungseinwirkung und einer Sinusfunktion in eine ihrem Produkt proportionale Impulsdauer äquivalent ist. Die bestehenden Kode-Impulsdauer-Wandler sind für die Wandlung der alternierenden Kodes bei einer linearen Anhängigkeit der Dauer des Ausgangsimpulses von deren Produkt nicht geeignet.

Es ist ein Kode-Impulsdauer-Wandler (SU,A,1064458) bekannt, der zwei Register, deren Eingängen Eingabekodes zugeführt werden und deren Schreibeingänge mit einer Schiene "Start" elektrisch verbunden sind, zwei Zähler, wobei die Kodeeingänge des einen von ihnen mit den Ausgängen des ersten Registers verbunden sind, einen Impulsgenerator, dessen Löscheingang mit der Schiene "Start" in Verbindung steht und dessen Ausgang mit den Zähleingängen des zweiten Zählers elektrisch verbunden ist, zwei 2-Eingangs-UND-Glieder enthält, bei denen die einen Eingänge mit dem Überlaufausgang des ersten Zählers elektrisch verbunden sind, die Ausgänge als Ausgänge des Wandlers dienen und die anderen Eingänge mit dem Ausgang der höchstwertigen Stelle des ersten Registers elektrisch verbunden sind.

Der bekannte Wandler gewährleistet keine lineare Abhängigkeit der Dauer des Ausgangsimpulses vom Produkt der Eingabekodes, was es nicht gestattet, den genannten Wandler zur Erzeugung von Steuerspannungen bei Stromrichtermotoren und anderen Stellwerken einzusetzen, deren Steuerungseinwirkung in Form eines Produkts zweier Kodes erzeugt wird. Der bekannte Wandler erlaubt es auch nicht, die Zusatzkodes über den zweiten Eingang umzuwandeln, was der Realisierung einer Reversiersteuerung der Belastung des Wandlers durch eine Elektronenrechenmaschine (EDVA) und durch andere digitale Steuereinrichtungen, bei denen die negativen Zahlen im Komplementkode dargestellt werden, im Wege steht.

Es ist ein Kode-Impulsdauer-Wandler ("Vestnik Belorusskogo gosudarstvennogo universiteta" ("Mitteilungen der Belorussischen staatlichen Universität", Bd. 1, Folge 1, 1987, Januar, (Minsk), A.B. Mikhalev e.a. "Tsifrovoi shirotno-impulsnyi modulator s peremnozhajuščimi vkhodami" ("Digitaler Impulsbreitenmodulator mit Multipliziereingängen"), S. 58 bis 60) bekannt, der zwei Register, deren Schreibeingänge an die Schiene "Start" und deren Ausgänge an die Kodeeingabeeingänge eines Impulsdauer-Formers, in dem an den Ausgang eines Zählsignalschalters der Zähleingang eines Zählers angeschlossen ist, dessen Überlaufausgang an den Sperreingang des Zählsignalschalters gelegt ist, bzw. eines gesteuerten Frequenzteilers geführt sind, und einen mit dem Eingang an die Schiene "Start" gelegten Impulsgenerator enthält, an den der Zähleingang des gesteuerten Frequenzteilers angeschlossen ist, dessen Ausgang zum Zähleingang des Impulsdauer-Formers geführt ist, dessen Starteingang an die Schiene "Start" gelegt und dessen Ausgang mit dem Ausgang des Kode-Impulsdauer-Wandlers elektrisch verbunden ist.

Der gesteuerte Frequenzteiler und der Impulsdauer-Former sind im bekannten Wandler aus Subtraktionszählern aufgebaut. Der Zählsignalschalter des Impulsdauer-Formers enthält ein 2-Eingangs-UND-Glied, dessen Ausgang an den Subtraktionseingang des Zählers des Impuls dauer-Formers und dessen Eingänge an den Borgausgang dieses Zählers bzw. an den Schreibeingang und den mit diesem zusammengeschalteten Borgausgang des Zählers des gesteuerten Frequenzteilers geführt sind.

Das Signal "Start" wird am Überlaufausgang des Zählers des gesteuerten Frequenzteilers erzeugt, dessen Zähleingang mit dem Ausgang des Generators verbunden ist. Der Einsatz der Subtraktionszähler im Impulsdauer-Former und im gesteuerten Frequenzteiler gestattet es nicht, ihren Betrieb zu ändern, was auf die Umwandlung der alternierenden Eingabekodes störend wirkt.

Der bekannte Wandler erlaubt es, in einem Direktkode dargestellte positive Zahlen in eine ihrem Produkt proportionale Impulsdauer umzuwandeln. Trotzdem gestattet der bekannte Wandler es nicht, im Komplementkode dargestellte negative Zahlen über die beiden Eingänge umzuwandeln, was die Anwendung des genannten Wandlers zur Reversiersteuerung der Mehrzahl der Stellwerke beschränkt, wodurch die Funktionsfähigkeiten und der Anwendungsbereich des Wandlers wesentlich eingeengt werden.

## Offenbarung der Erfindung

Der Erfindung liegt die Aufgabe zugrunde, einen Kode-Impulsdauer-Wandler zu schaffen, in dem durch Einsatz eines Zählers und durch Einführung eines mit diesem verbundenen Zusatzteiles in den Impulsdauer-Former die Formierung der Impulsdauer unter Beachtung des Vorzeichens des Produkts der Eingabekodes geschieht, wobei die Impulsdauer dem Produkt der Module der letzteren proportional ist.

Die gestellte Aufgabe wird dadurch gelöst, daß in dem Kode-Impulsdauer-Wandler, der zwei Register, deren Schreibeingänge an die Schiene "Start" und deren Ausgänge an die Kodeeingabeeingänge eines Impulsdauer-Formers, in dem an den Ausgang eines Zählsignalschalters der Zähleingang eines Zählers angeschlossen ist, dessen Überlaufausgang an den Sperreingang des Zählsignalschalters gelegt ist, bzw. eines gesteuerten Frequenzteilers geführt sind, und einen mit dem Eingang an die Schiene "Start" gelegten Impulsgenerator enthält, an den der Zähleingang des gesteuerten Frequenzteilers angeschlossen ist, dessen Ausgang zum Zähleingang des Impulsdauer-Formers geführt ist, dessen Starteingang an die Schiene "Start" und dessen Ausgang mit dem Ausgang des Kode-Impulsdauer-Wandlers elektrisch verbunden ist, gemäß der Erfindung der Zähler des Impulsdauer-Formers reversierbar ausgeführt, der Zählsignalschalter mit einem Eingang zur Polaritätseinstellung und mit einem zusätzlichen Sperreingang sowie einem Ausgang versehen ist, die jeweils an den Informationseingang der höchstwertigen Stelle des Reversierzählers an dessen anderen Überlaufeingang und an dessen Zähleingang geführt sind, und daß zusätzlich ein Ausgangssignalschalter zur Verfügung steht, dessen Eingänge an die Ausgänge des Impulsdauer-Formers, dessen Steuereingang an den Ausgang der höchstwertigen Stelle des einen Registers gelegt sind und dessen Ausgänge als Ausgänge des Kode-Impulsdauer-Wandlers auftreten.

Es ist zweckmäßig, daß der Zählsignalschalter des Impulsdauer-Formers vier 2-Eingangs-UND-NICHT-Glieder, bei denen die einen Eingänge des ersten und zweiten Gliedes zusammengeschaltet sind und als Zähleingang des Zählsignalschalters dienen, die anderen Eingänge jeweils als Haupt- und zusätzlicher Sperreingang auftreten und die Ausgänge an die einen Eingänge des dritten und vierten 2-Eingangs-UND-NICHT-Gliedes angeschlossen sind, deren Ausgänge als Haupt- und Zusatzausgang des Zählsignalschalters dienen, und einen Negator enthält, dessen Eingang mit dem anderen Eingang des dritten 2-Eingangs-UND-NICHT-Gliedes verbunden ist und als Eingang zur Polaritätseinstellung des Zählsignalschalters dient und dessen Ausgang an den anderen Eingang des vierten 2-Eingangs-UND-NICHT-Gliedes geführt ist.

Sinnvoll ist, daß der Ausgangssignalschalter drei 2-Eingangs-UND-Glieder, wobei die Eingänge des ersteren von ihnen als dessen Eingänge dienen und der Ausgang an die einen Eingänge des zweiten und dritten 2-Eingangs-UND-Gliedes angeschlossen ist, deren Ausgänge als Ausgänge des Ausgangssignalschalters dienen, und einen Negator enthält, dessen Ausgang an den anderen Eingang des dritten 2-Eingangs-UND-Gliedes gelegt und dessen Eingang mit dem anderen Eingang des zweiten 2-Eingangs-UND-Gliedes verbunden ist.

Der erfindungsgemäße Kode-Impulsdauer-Wandler gestattet es, sowohl Direkt- als auch Komplement-Eingabekodes in eine dem Produkt ihrer Module proportionale Impulsdauer umzuwandeln, wobei der Ausgangsimpuls an einem der zwei Ausgänge des Wandlers unter Beachtung des Vorzeichens des Produkts erzeugt wird, wodurch die Einfachheit des Interface zwischen dem Wandler und einem Steuerrechner gewährleistet sowie eine Reversiersteuerung der Belastung über einen der Eingänge des Wandlers ermöglicht werden. Die durch eine geringfügige Komplizierung der Schaltung in einer der Ausführungsformen des Wandlers realisierte Möglichkeit der Umwandlung der alternierenden Eingabekodes über die beiden Eingänge erlaubt es, den Wandler zur Steuerung der über die beiden Eingänge reversierbaren Belastung einzusetzen, was das Anwendungsgebiet und die Funktionsfähigkeiten des erfindungsgemäßen Kode-Impulsdauer-Wandlers wesentlich erweitert.

## Kurze Beschreibung der Zeichnungen

Die Erfindung soll durch die nachstehende Beschreibung konkreter Ausführungsformen und der Zeichnungen näher erläutert werden. Es zeigt:

Fig. 1 ein Funktionsschaltbild eines erfindungsgemäßen Kode-Impulsdauer-Wandlers;

Fig. 2 dto. wie in Fig. 1 mit einem Zählsignalschalter und einem Reversierzähler eines gesteuerten Frequenzteilers;

Fig. 3 Zeitdiagramme der Funktionsweise des Kode-Impulsdauer-Wandlers nach Fig. 1, 2.

## Bevorzugte Ausführungsform der Erfindung

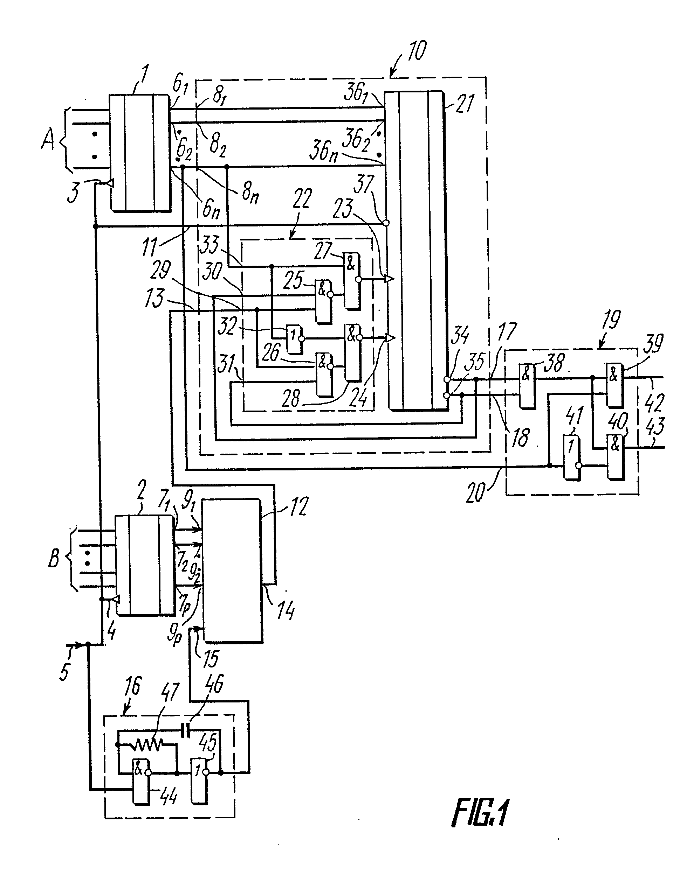

Der Kode-Impulsdauer-Wandler enthält ein n-Bit-Register 1 (Fig. 1) und ein p-Bit-Register 2, deren Schreibeingänge 3, 4 an eine Schiene 5 "Start" gelegt sind und an deren Informationseingänge Eingabekodes A und B des Kode-Impulsdauer-Wandlers gelangen. Die Ausgänge $6 \ldots 6_n$, $7 \ldots 7_p$ der Register 1,2 sind an die Kodeeingabeeingänge $8_1 \ldots 8_n$, $9_1 \ldots 9_p$ eines Impulsdauer-Formers 10, dessen Starteingang an die Schiene 5 "Start" gelegt ist, bzw. eines gesteuerten Frequenzteilers 12 geschaltet. Der Zähleingang 13 des Impulsdauer-Formers 10 ist an den Ausgang 14 des gesteuerten Frequenzteilers 12 angeschlossen, dessen Zähleingang 15 an den Ausgang eines Impulsgenerators 16 geführt ist, dessen Eingang an der Schiene 5 "Start" anliegt.

An die Ausgänge 17, 18 des Impulsdauer-Formers 10 ist ein Ausgangssignalschalter 19 gelegt, dessen Steuereingang 20 an den Ausgang $6_n$ der höchstwertigen Stelle des n-Bit-Registers 1 geführt ist.

Der Impulsdauer-Former 10 enthält einen Reversierzähler 21 und einen Zählsignalschalter 22, dessen Ausgänge an die Zähleingänge 23, 24 (Summiereingang 23, Subtrahiereingang 24) des Reversierzählers 21 geschaltet sind. Der Zählsignalschalter 22 enthält vier 2-Eingangs-UND-NICHT-Glieder 25, 26, 27, 28, bei denen die einen Eingänge der 2-Eingangs-UND-NICHT-Glieder 25, 26 zusammengeschaltet sind und als Zähleingang 29 des Zählsignalschalters 22 dienen, deren andere Eingänge als Sperreingänge 30, 31 des Zählsignalschalters 22 auftreten und deren Ausgänge an die einen Eingänge der 2-Eingangs-UND-NICHT-Glieder 27, 28 angeschlossen sind, deren Ausgänge als Ausgänge des Zählsignalschalters 22 dienen. An den anderen Eingang des 2-Eingangs-UND-NICHT-Gliedes 27 ist der Eingang eines Negators 32 angeschlossen, der als Eingang 33 zur Polaritätseinstellung des Zählsignalschalters 22 dient, während der Ausgang des Negators 32 an den anderen Eingang des 2-Eingangs-UND-NICHT-Gliedes 28 gelegt ist.

Die Überlaufausgänge 34, 35 (Übertragsausgang 34, Borgausgang 35) des Reversierzählers 21 sind mit den Sperreingängen 30, 31 des Zählsignalschalters 22 verbunden und wirken als Ausgänge 17, 18 des Impulsdauer-Formers 10. Die Informationseingänge $36_1 \ldots 36_n$ des Reversierzählers 21 dienen als Eingänge $8_1 \ldots 8_n$ zur Kodeeingabe des Impulsdauer-Formers 10, während dessen Starteingang 11 mit dem Schreibeingang 37 des Reversierzählers 21 verbunden ist. Der Eingang 33 zur Polaritätseinstellung des Zählsignalschalters 22 ist mit dem Informationseingang $36_n$ der höchstwertigen Stelle des Reversierzählers 21 verbunden, und der Zähleingang 29 des Zählsignalschalters 22 tritt als Zähleingang 13 des Impulsdauer-Formers 10 auf.

Der Ausgangssignalschalter 19 enthält drei 2-Eingangs-UND-Glieder 38, 39, 40 und einen Negator 41. Die Eingänge des 2-Eingangs-UND-Gliedes 38 dienen als Eingänge des Ausgangssignalschalters 19 und dessen Ausgang ist an die einen Eingänge der 2-Eingangs-UND-Glieder 39,40 angeschlossen, deren Ausgänge als Ausgänge 42, 43 des Ausgangssignalschalters 19 auftreten. Der Ausgang des Negators 41 ist an den anderen Eingang des 2-Eingangs-UND-Gliedes 40 gelegt, während dessen Eingang mit dem anderen Eingang des 2-Eingangs-UND-Gliedes 39 verbunden ist und als Steuereingang 20 des Ausgangssignalschalters 19 fungiert.

Der gesteuerte Frequenzteiler 12 ist in der beschriebenen Ausführungsform aus einem Subtraktionszähler aufgebaut, dessen Borgausgang mit dem Schreibeingang verbunden ist und als Ausgang 14 des gesteuerten Frequenzteilers 12 dient.

In der beschriebenen Ausführungsform weist der Impulsgenerator 16 ein 2-Eingangs-UND-NICHT-Glied 44 auf, dessen Ausgang mit dem Eingang eines Negators 45 verbunden ist. Der Ausgang des Negators 45 dient als Ausgang des Impulsgenerators 16 und ist über einen Kondensator 46 mit einem Eingang des 2-Eingangs-UND-NICHT-Gliedes 44 verbunden, der über einen ohmschen Widerstand 47 mit dessen Ausgang zusammengeschaltet ist. Der andere Eingang des 2-Eingangs-UND-NICHT-Gliedes 44 tritt als Löscheingang des Impulsgenerators 16 auf und ist an die Schiene 5 "Start" gelegt.

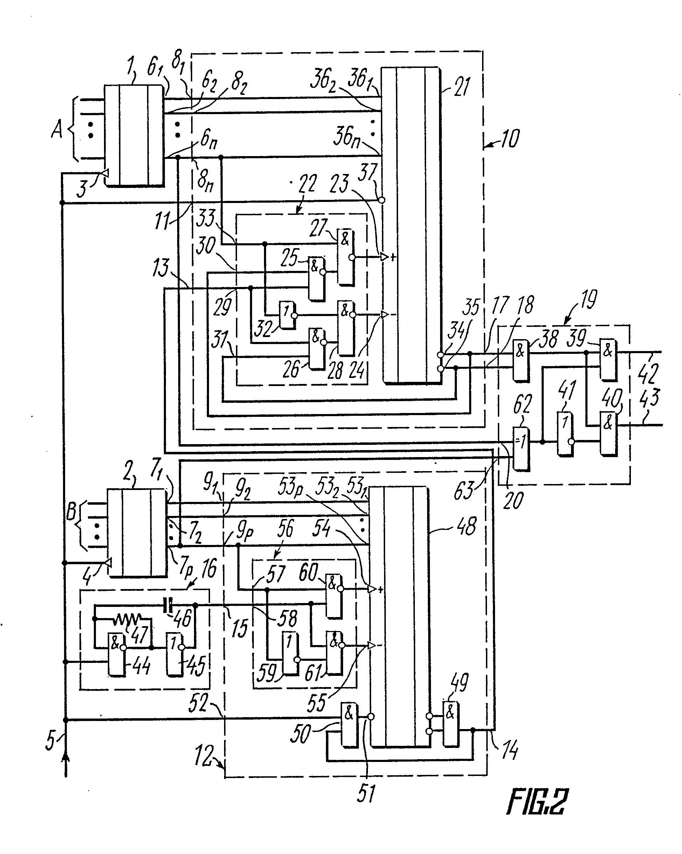

In der anderen in Fig. 2 dargestellten Ausführungsform des Kode-Impulsdauer-Wandlers sind der Impulsdauer-Former 10 und der Impulsgenerator 16 in Analogie zum oben Beschriebenen ausgeführt, während der gesteuerte Frequenzteiler 12 einen Reversierzähler 48 enthält, an dessen Überlaufausgänge die Eingänge eines 2-Eingangs-UND-Gliedes 49 gelegt sind, dessen Ausgang als Ausgang 14 des gesteuerten Frequenzteilers 12 dient. An den Ausgang des 2-Eingangs-UND-Gliedes 49 ist ein Eingang eines 2-Eingangs-UND-Gliedes 50 angeschlossen, dessen Ausgang zum Schreibeingang 51 des Reversierzählers 48 geführt ist und dessen anderer Eingang als Löscheingang 52 des gesteuerten Frequenzteilers 12 dient und an der Schiene 5 "Start" anliegt.

Die Informationseingänge $53_1 \ldots 53_p$ des Reversierzählers 48 wirken als Kodeeingabeeingänge $9_1 \ldots 9_p$ des gesteuerten Frequenzteilers 12, und an die Zähleingänge 54, 55 (Summiereingang 54, Subtrahiereingang 55) des Reversierzählers 48 ist ein Zählsignalschalter 56 des gesteuerten Frequenzteilers 12 angeschlossen. Der Eingang 57 zur Polaritätseinstellung des Zählsignalschalters 56 ist an den Informationseingang $53_p$ der höchstwertigen Stelle des Reversierzählers 48 gelegt, während der Zähleingang 58 des Zählsignalschalters 56 als Zähleingang 15 des gesteuerten Frequenzteilers 12 auftritt.

Der Zählsignalschalter 56 enthält in der beschriebenen Ausführungsform einen Negator 59 und zwei 2-Eingangs- UND-NICHT-Glieder 60,61, deren eine Eingänge zusammengeschaltet sind und als Zähleingang 58 des Zählsignalschalters 56 dienen, als dessen Ausgänge deren Ausgänge auftreten.

Der andere Eingang des 2-Eingangs-UND-NICHT-Gliedes 61 ist an den Ausgang des Negators 59 geführt, dessen Eingang an den anderen Eingang des 2-Eingangs-UND-NICHT-Gliedes 60 geschaltet ist und als Eingang 57 zur Polaritätseinstellung des Zählsignalschalters 56 auftritt.

Der Ausgangssignalschalter 19 ist in Analogie zum oben Beschriebenen ausgeführt und enthält zusätzlich ein Exklusiv-ODER-Glied 62, dessen Eingänge als Steuereingänge 20,63 des Ausgangssignalschalters 19 auftreten und dessen Ausgang an den Eingang des Negators 41 gelegt ist. Der Steuereingang 63 des Ausgangssignalschalters 19 ist an den Ausgang $7_p$ des p-Bit-Registers 2 geführt.

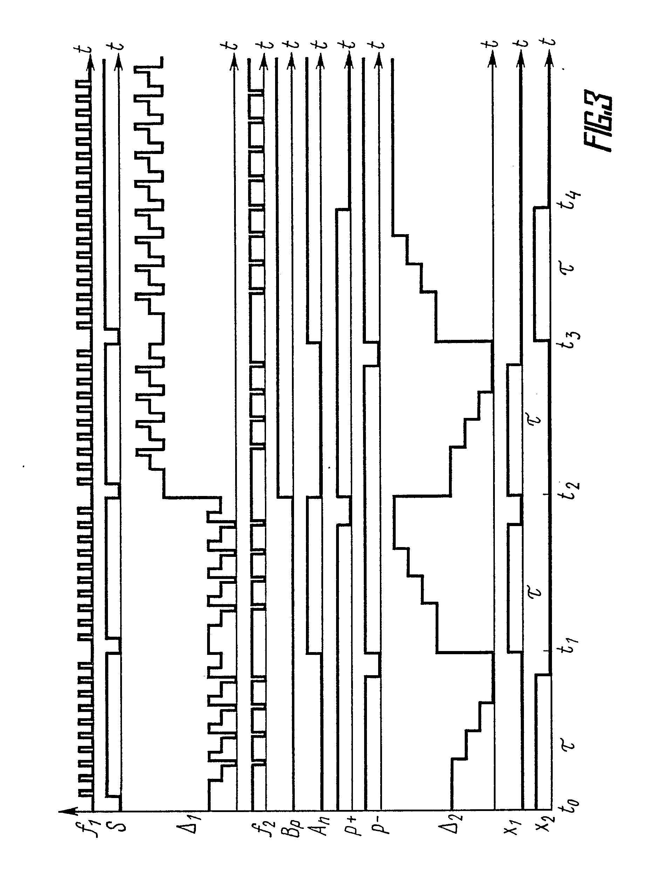

Die die Arbeit der Kode-Impulsdauer-Wandler nach Fig. 1, 2 veranschaulichenden Zeitdiagramme sind in Fig. 3 wiedergegeben. Auf der Abszissenachse ist die Zeit t und auf der Ordinatenachse in Richtung von oben nach unten: Ausgangsimpulse des Impulsgenerators 16 mit einer Frequenz $f_1$: Signal S "Start" auf der Schiene 5 "Start"; Ausgabekode $\Delta_1$ des Zählers 48 des gesteuerten Frequenzteilers 12; Ausgangsimpulse mit einer Frequenz $f_2$ am Ausgang 14 des gesteuerten Frequenzteilers 12: Werte $B_p$, $A_n$ der höchstwertigen Stellen der Eingabekodes B, A des Kode-Impulsdauer-Wandlers; Signals $P_+$, $P_-$ am Übertrags-und Borgausgang 34 bzw. 35 des Reversierzählers 21 des Impulsdauer-Formers 10; Ausgabekode $\Delta_2$ des Zählers 21 des Impulsdauer-Formers 10; Signale $X_1$, $X_2$ an den Ausgängen 42, 43 des Kode-Impulsdauer-Wandlers aufgetragen. Die Arbeit des in Fig. 1 dargestellten Wandlers wird in Fig. 3 in einem Zeitintervall /$t_0$, $t_2$/ bei Stellenzahlen n = p = 3 der Register 1, 2 und bei Eingabekodes

$A_1 = 3_{/10/} = 011_{/2/}$, $A_2 = -4_{/10/} = 100_{/2/}$

veranschaulicht. Die Arbeit des in Fig. 2 dargestellten Wandlers wird in Fig. 3 in einem Zeitintervall /$t_0$, $t_4$/ bei Stellenzahlen n = p = 3 der Register 1,2 und bei Eingabekodes

$A_1 = 3_{/10/} = 011_{/2/}$, $A_2 = -4_{/10/} = 100_{/2/}$
$B_1 = 2_{/10/} = 010_{/2/}$, $B_2 = -3_{/10/} = 101_{/2/}$

veranschaulicht.

Der Kode-Impulsdauer-Wandler arbeitet wie folgt.

Beim Eintreffen eines durch ein externes Gerät, beispielsweise durch einen Mikrorechner, erzeugten 0-Impulses an der Schiene 5 (Fig. 1) "Start" wird der Impulsgenerator 16 in den Anfangszustand versetzt, in dem die Impulserzeugung aufhört, das Signal am Ausgang des Negators 45 nimmt einen 0-Pegel an, die durch das externe Gerät erzeugten Eingabekodes A, B des Wandlers werden jeweils in das n-Bit-Register 1, den Reversierzähler 21 des Impulsdauer-Formers 10 und in das n-Bit-Register 2 eingeschrieben.

Nach dem Übergang des Signals PS "Start" in den 1-Zustand (Zeitpunkte $t_0$, $t_1$ (Fig. 3) beginnt der Impulsgenerator 16 (Fig. 1) Impulse mit einer Frequenz $f_1$ (Fig. 3) zu generieren, die am Zähleingang 15 (Fig. 1) des gesteuerten Frequenzteilers 12 ankommen. Mit der Flanke jedes Impulses der Frequenz $f_1$ (Fig. 3) wird der Ausgabekode $\Delta_1$ des Subtraktionszählers des gesteuerten Frequenzteilers 12 (Fig. 1) um eins kleiner. Ist der Kode $\Delta_1$ - (Fig. 3) gleich Null und trifft am Zähleingang 15 des gesteuerten Frequenzteilers 12 ein weiterer 0-Impuls vom Impulsgenerator 16 (Fig. 1) ein, nimmt das Signal am Borgausgang des Subtraktionszählers, der mit dessen Schreibeingang verbunden ist, einen Tiefpegel an, weshalb der Kode B vom Ausgang des p-Bit-Registers 2 in den Subtraktionszähler des gesteuerten Frequenzteilers 12 eingetragen wird, worauf sich der beschriebene Vorgang der Verkleinerung des Kodes $\Delta_1$ (Fig. 3) und der Eintragung des Kodes B bei Nullgleichheit des Borgsignals wiederholt. Die 0-Impulse am Borgausgang des Subtraktionszählers, der als Ausgang 14 (Fig. 1) des gesteuerten Frequenzteilers 12 auftritt, weisen also eine Dauer, die der Verzögerungszeit der Ausbreitung des Signals des Subtraktionszählers gleich ist, und eine Frequenz

$f_2 = f_1/B$     (1)

auf.

Die die Frequenz $f_2$ (Fig. 3) aufweisenden Impulse vom Ausgang 14 des gesteuerten Frequenzteilers 12 kommen an Zähleingang 13 (Fig. 1) des Impulsdauer-Formers 10 an.

Beim Eintreffen eines 0-Signals S "Start" am Schreibeingang 3 des Reversierzählers 21 wird ein Kode A in den Zähler 21 eingeschrieben. Die positiven Kodes A (Zeitpunkt $t_0$ (Fig. 3) werden in einem direkten Binärkode dargestellt, wobei die höchstwertige Stelle $A_n$ des Kodes A am Ausgang $6_n$ (Fig. 1) des Registers 1 gleich Null, das Signal am Ausgang des Negators 32 gleich Eins ist und die Impulse der Frequenz $f_2$ (Fig. 3) vom Ausgang 14 (Fig. 1) des gesteuerten Frequenzteilers 12 über die 2-Eingangs-UND-NICHT-Glieder 26, 28 auf den Subtraktionseingang 24 des Zählers 21 gelangen, wodurch dessen Ausgabekode $\Delta_2$ (Fig. 3) um eins verkleinert wird. Bei Nullgleichheit des Kodes $\Delta_2$ läßt ein weiterer Impuls der Frequenz $f_2$ vom Ausgang 14 (Fig. 1) des gesteuerten Frequenzteilers 12 am Zähleingang 13 des Impulsdauer-Formers 10 das Signal $P_-$ (Fig. 3) am Borgausgang 35 (Fig.

1) des Zählers 21 einen Tiefpegel annehmen, wodurch am Subtraktionseingang 24 des Zählers 21 mittels der 2-Eingangs-UND-NICHT-Glieder 26, 28 ein logisch 0 unabhängig vom Signal am Zähleingang 13 des Impulsdauer-Formers 10 aufrechterhalten werden wird. Nach dem Übergang des Signals P- (Fig. 3) auf logisch 0 wird also die weitere Zählung im Zähler 21 (Fig. 1) gesperrt, und das Signal P- (Fig. 3) am Borgausgang 35 (Fig. 1) des Zählers 21 wird gleich Null sein, bis ein weiterer Impuls S "Start" angekommen ist.

Bei der Umwandlung der im Komplementkode (Zeitpunkt $t_1$ (Fig. 3) dargestellten negativen Kodes A ist die höchstwertige Stelle $A_n$ des Kodes A am Ausgang $6_n$ (Fig. 1) des Registers 1 gleich Eins, weshalb die Impulse der Frequenz $f_2$ (Fig. 3) vom Ausgang 14 (Fig. 1) des gesteuerten Frequenzteilers 12 über die 2-Eingangs-UND-NICHT-Glieder 25, 27 auf den Summiereingang 23 des Zählers 21 gelangen, wodurch sein Ausgabekode $\Delta_2$ (Fig. 3) erhöht wird. In dem Augenblick, wo der Kode $\Delta_2$ dem Maximalwert $2^n - 1$ gleich ist, löst das Eintreffen eines weiteren Impulsen der Frequenz $f_2$ vom Ausgang 14 (Fig. 1) des gesteuerten Frequenzteilers 12 am Zähleingang 13 des Impulsdauer-Formers 10 einen Übergang des Signals P+ (Fig. 3) am Übertragsausgang 34 (Fig. 1) des Zählers 21 auf einen Tiefpegel aus, wonach das Signal am Summiereingang 23 des Zählers 21 mit Hilfe der 2-Eingangs-UND-NICHT-Glieder 25, 27 auf logisch 0 unabhängig vom Signal am Zähleingang 13 des Impulsdauer-Formers 10 aufrechterhalten werden wird.

Nach dem Übergang des Signals P+ (Fig. 3) auf logisch 0 wird also die weitere Zählung im Zähler 21 (Fig. 1) gesperrt und das Signal P+ (Fig. 3) am Übertragsausgang 34 (Fig. 1) des Zählers 21 gleich Null sein, bis ein weiterer Impuls S "Start" angekommen ist.

Der Zählsignalschalter 22 sorgt also für eine Umwandlung von Direkt- oder Komplementkodes A im Subtraktions- oder Summationsbetrieb des Zählers 21 und für eine Sperrung der Zählung, wenn der Ausgabekode $\Delta_2$ (Fig. 3) des Zählers 21 (Fig. 1) gleich Null oder maximal ist, weshalb das Signal an dessen Borgausgang 35 oder Übertragsausgang 34 eine Dauer

$$\tau = /A/ : f_2 = /A/ \cdot B : f_1 \qquad (2)$$

aufweist.

Der Ausgangssignalschalter 19 sichert bei Berücksichtigung des Vorzeichens des Produkts A, B eine Verteilung der Signale von den Ausgängen 17, 18 des Impulsdauer-Formers 10 auf die Ausgänge 42, 43 des Wandlers. Die 1-Impulse der Dauer $\tau$ vom Ausgang des 2-Eingangs-UND-Gliedes 38 bewirken bei der Umwandlung von negativen Kodes A die Erzeugung eines 1-Impulses $X_1$ (Fig. 3) an dem Ausgang des 2-Eingangs-UND-Gliedes 39 (Fig. 1), der als Ausgang 42 des Wandlers fungiert. Bei der Umwandlung von positiven Kodes A ist die höchstwertige Stelle $A_n$ des Kodes A am Ausgang $6_n$ des Registers 1 gleich Null, das Signal am Ausgang des Negators 41 erreicht einen Hochpegel, weshalb das Signal $X_1$ (Fig. 3) am Ausgang 42 (Fig. 1) des Wandlers auf einem Tiefpegel liegt, und am Ausgang 43 wird ein 1-Signal $X_2$ (Fig. 3) mit der Dauer $\tau$ (2) erzeugt.

Auf solche Weise gewährleistet der erfindungsgemäße Wandler die Umwandlung eines alternierenden Kodes A und eines Kodes B mit konstanten Vorzeichen in eine ihrem Produkt proportionale Impulsdauer, wobei bei einem positiven Vorzeichen des Produkts des Ausgangsimpuls am Ausgang 43 (Fig. 1) und bei einem negativen Vorzeichen am Ausgang 42 des Wandlers erzeugt wird.

Zur Umwandlung der alternierenden Eingabekodes nicht nur über den Eingang A, sondern auch über den Eingang B wird von der in Fig. 2 dargestellten Ausführungsform des Kode-Impulsdauer-Wandlers Gebrauch gemacht.

Die Umwandlung der alternierenden Kodes über den Eingang A des Wandlers erfolgt analog dem oben Beschriebenen. Beim Eintreffen eines 0-Impulses an der Schiene 5 (Fig. 2) "Start" nimmt das Signal am Ausgang des 2-Eingangs-UND-Gliedes 50 des gesteuerten Frequenzteilers 12 einen 0-Wert an, worauf der Kode B in den Reversierzähler 48 eingeschrieben wird, dessen Übertrags- und Borgsignal hierbei einen 1-Wert annehmen. Nach Abklingen des Impulses S "Start" beginnen die Impulse vom Ausgang des Impulsgenerators 16 am Zähleingang 15 des gesteuerten Frequenzteilers 12 anzukommen.

Bei der Umwandlung der positiven Kodes B (Zeitpunkte $t_0$, $t_1$ (Fig. 3), die im Direktkode dargestellt sind, ist die höchstwertige Stelle $B_p$ des Kodes B am Ausgang $7_p$ (Fig. 2) des Registers 2 gleich Null, das Ausgangssignal des Negators 59 des Zählsignalschalters 56 hat einen Hochpegel, und die Impulse der Frequenz $f_1$ (Fig. 3) gelangen vom Ausgang des Impulsgenerators 16 (Fig. 2) über das 2-Eingangs-UND-NICHT-Glied 61 auf den Subtrahiereingang 55 des Reversierzählers 48. Das Eintreffen jedes Impulses der Frequenz $f_2$ (Fig. 2) bewirkt eine Verkleinerung des Ausgabekodes $\Delta_1$ des Zählers 48 (Fig. 2) um eins.

In dem Augenblick, wo der Ausgabekode $\Delta_1$ - (Fig. 3) gleich Null ist, läßt ein weiterer 0-Impuls am Zähleingang 15 (Fig. 2) des gesteuerten Frequenzteilers 12 ein 0-Signal am Borgausgang des Zählers 48 und an den Ausgängen der 2-Eingangs-UND-Glieder 49, 50 erscheinen, weshalb der Kode B in den Zähler 48 eingeschrieben wird, worauf sich der beschriebene Vorgang wiederholt.

Bei der Umwandlung der negativen Kodes B (Zeitpunkte $t_2$, $t_3$ (Fig. 3), die im Komplementkode dargestellt sind, ist die höchstwertige Stelle $B_p$ des Kodes B am Ausgang .$7_p$ (Fig. 2) des Registers gleich Eins, und die Impulse der Frequenz $f_1$ (Fig. 3) gelangen vom Ausgang des Impulsgenerators 16 (Fig. 2) über das 2-Eingangs-UND-NICHT-Glied 60 auf den Summiereingang 54 des Reversierzählers 48.

Das Eintreffen jedes Impulses der Frequenz $f_1$ (Fig. 3) bewirkt eine Erhöhung des Ausgabekodes $\Delta_1$ des Zählers 48 um eins.

Nach Erreichen des Maximalwertes $2^p - 1$ durch den Kode $\Delta_1$ bewirkt das Eintreffen eines weiteren 0-Impulses am Zähleingang 15 (Fig. 2) des gesteuerten Frequenzteilers 12 das Auftreten eines O-Signals am Übertragsaus gang des Zählers 48 und an den Eingängen der 2-Eingangs-UND-Glieder 49, 50, weshalb der Kode B in den Zähler 48 eingetragen wird, worauf sich der oben beschriebene Vorgang wiederholt. .

Die 0-Impulse am Ausgang 14 des gesteuerten Frequenzteilers 12 weisen also eine Dauer, die der gesamten Verzögerungszeit der Signalausbreitung in den 2-Eingangs-UND-Gliedern 49, 50 und im Zähler 48 gleich ist, und eine Frequenz

$$f_2 = f_1 : /B/ \qquad (3)$$

auf.

Die die Frequenz $f_2$ aufweisenden Impulse vom Ausgang 14 des gesteuerten Frequenzteilers 12 gelangen auf den Zähleingang 13 des Impulsdauer-Formers 10, der analog dem oben Beschriebenen arbeitet.

Die Ausgangsimpulse des Impulsdauer-Formers 10 besitzen eine Dauer

$$\tau = /A/ : f_2 = /A/ \cdot /B/ : f_1 \qquad (4)$$

Der Ausgangssignalschalter 19 sorgt also unter Berücksichtigung des Vorzeichens des Produkts AB für eine Verteilung der Signale von den Ausgängen 17, 18 des Impulsdauer-Formers 10 auf die Ausgänge 42, 43 des Wandlers.

Bei Nichtkoinzidenz der Vorzeichen der Kodes A, B hat das Produkt AB ein negatives Vorzeichen, das Signal am Ausgang des Exklusiv-ODER-Gliedes 62 ist gleich Eins, und am Ausgang des 2-Eingangs-UND-Gliedes 39 wird ein 1-Signal $X_1$ - (Fig. 3) mit der Dauer $\tau$ erzeugt. Bei Koinzidenz der Vorzeichen der Kodes AB ist das Signal am Ausgang des Exklusiv-ODER-Gliedes 62 (Fig. 2) gleich Null, das Ausgangssignal des Negators 41 ist gleich Eins, und das Ausgangssignal $X_2$ (Fig. 3) der Dauer $\tau$ wird am Ausgang des 2-Eingangs-UND-Gliedes 40 (Fig. 2) erzeugt.

Die oben behandelte Ausführungsform des Wandlers si chert die Umwandlung von zwei alternierenden Kodes A, B in eine ihrem Produkt proportionale Impulsdauer, wobei bei einem positiven Vorzeichen des Produkte des Ausgangsimpuls am Ausgang 43 und be einem negativen Vorzeichen am Ausgang 42 des Wandlers auftritt.

Der erfindungsgemäße Kode-Impulsdauer-Wandler gestattet es also, alternierende Eingabekodes so über einen wie auch über zwei Eingänge umzuwandeln, was eine Reversiersteuerung der Belastung und einen einfachen Aufbau eines Interface zu einer Steuereinrichtung ermöglicht.

### Industrielle Anwendbarkeit

Die vorliegende Erfindung kann in Impulsbreitenreglern verschiedener Stellwerke, beispielsweise in Elektroantrieben von elektromechanischen Robotern und in numerisch gesteuerten Werkzeugmaschinen angewendet werden.

### Ansprüche

1. Kode-Impulsdauer-Wandler, der zwei Register (1, 2), deren Schreibeingänge (3,4) an die Schiene (5) "Start" und deren Ausgänge ($6_1...6_n$), ($7_1...7_p$) an die Kodeeingabeeingänge ($8_1...8_n$, $9_1...9_p$) eines Impulsdauer-Formers (10), in dem an den Ausgang eines Zählsignalschalters (22) der Zähleingang (23) eines Zählers (21) angeschlossen ist, dessen Überlaufausgang (34) an den Sperreingang (30) des Zählsignalschalters (22) gelegt ist, bzw. eines gesteuerten Frequenzteilers (12) geführt sind, und einen mit dem Eingang an die Schiene (5) "Start" gelegten Impulsgenerator (16) enthält, an den der Zähleingang (15) des gesteuerten Frequenzteilers (12) angeschlossen ist, dessen Ausgang (14) zun Zähleingang (13) des Impulsdauer-Formers (10) geführt ist, dessen Starteingang (11) an die Schiene (5) "Start" gelegt und dessen Ausgang (17) mit dem Ausgang des Kode-Impulsdauer-Wandlers elektrisch verbunden ist, **dadurch gekennzeichnet**, daß der Zähler (21) des Impulsdauer-Formers (10) reversierbar ausgeführt, der Zählsignalschalter (22) mit einem Eingang (33) zur Polaritätseinstellung und mit einem zusätzlichen Sperreingang (31) sowie mit einem Ausgang versehen ist, die jeweils an den Informationseingang ($36_n$) der höchstwertigen Stelle des Reversierzählers (21), an dessen anderen Überlaufausgang (35) und an dessen Zähleingang (24) geführt sind, und daß zusätzlich ein Ausgangssignalschalter (19) zur Verfügung steht, dessen Eingänge an die Ausgänge (17, 18) des Impulsdauer-Formers (10) und dessen Steuereingang (20) an den Ausgang ($6_n$) der höchstwertigen Stelle des einen Registers (1) gelegt sind und dessen Ausgänge (42, 43) als Ausgänge des Kode-Impulsdauer-Wandlers auftreten.

2. Wandler nach Anspruch 1, **dadurch gekennzeichnet**, daß der Zählsignalschalter (22) des Impulsdauer-Formers (10) vier 2-Eingangs-UND-NICHT- Glieder (25, 26, 27, 28), bei denen die einen Eingänge des ersten und zweiten Gliedes zusammengeschaltet sind und als Zähleingang (29) des Zählsignalschalters (22) dienen, die anderen Eingänge jeweils als Haupt- und zusätzlicher Sperreingang (30 bzw. 31) auftreten und die Ausgänge an die einen Eingänge des dritten und vierten 2-Eingang-UND-NICHT-Gliedes (27 bzw. 28) angeschlossen sind, deren Ausgänge als Haupt- und Zusatzausgang des Zählsignalschalters (22) dienen, und einen Negator (32) enthält, dessen Eingang mit dem anderen Eingang des dritten 2-Eingangs-UND-NICHT-Gliedes (27) verbunden ist und als Eingang (33) zur Polaritätseinstellung des Zählsignalschalters (22) dient und dessen Ausgang an den anderen Eingang des vierten 2-Eingangs-UND-NICHT-Gliedes (28) geführt ist.

3. Wandler nach den Ansprüchen 1,2, **dadurch gekennzeichnet**, daß der Ausgangssignalschalter (19) drei 2-Eingangs-UND-Glieder (38, 39, 40), wobei die Eingänge des ersteren von ihnen als dessen Eingänge dienen und der Ausgang an die einen Eingänge des zweiten und dritten 2-Eingangs-UND-Gliedes (39 bzw. 40) angeschlossen ist, deren Ausgänge als Ausgänge (42, 43) des Ausgangssignalschalters (19) dienen, und einen Negator (41) enthält, dessen Ausgang an den anderen Eingang des dritten 2-Eingangs-UND-Gliedes (40) gelegt und dessen Eingang mit dem anderen Eingang des zweiten 2-Eingangs-UND-Gliedes (39) verbunden ist.

4. Wandler nach Anspruch 3, **dadurch gekennzeichnet**, daß beim Vorhandensein eines Zählers (48) im gesteuerten Frequenzteiler (12), dessen Überlaufausgang mit dem Schreibeingang (51) elektrisch verbunden ist, der Zähler (48) reversierbar ausgeführt ist und der gesteuerte Frequenzteiler (12) zusätzlich einen Zählsignalschalter (56), dessen Eingang (57) zur Polaritätseinstellung an den Informationseingang ($53_p$) der höchstwertigen Stelle des Reversierzählers (48) gelegt ist, dessen Zähleingang (58) als Zähleingang (15) des gesteuerten Frequenzteilers (12) dient und dessen Ausgänge an die Zähleingänge (54, 55) des Reversierzählers (48) geführt sind, und zwei 2-Eingangs-UND-Glieder (49,50) enthält, wobei die Eingänge des ersteren von ihnen an die Überlaufausgänge des Reversierzählers (48) angeschlossen sind und dessen Ausgang als Ausgang (14) des gesteuerten Frequenzteilers (12) auftritt und an einem Eingang des zweiten 2-Eingangs-UND-Gliedes (50) anliegt, dessen Ausgang an den Schreibeingang (51) des Reversierzählers (48) gelegt ist und dessen anderer Eingang als Löscheingang (52) des gesteuerten Frequenzteilers (12) wirkt, wobei der Ausgangssignalschalter (19) zusätzlich ein Exklusiv-ODER-Glied (62) aufweist, dessen Ausgang an den Eingang des Negators (41) angeschlossen ist und dessen Eingänge als Haupt- und als am Ausgang ($7_p$) der höchstwertigen Stelle des anderen Registers (2) anliegender zusätzlicher Steuereingang (20 bzw. 63) des Ausgangssignalschalters (19) auftreten.

5. Wandler nach Anspruch 4, **dadurch gekennzeichnet**, daß der Zählsignalschalter (56) des gesteuerten Frequenzteilers (12) zwei 2-Eingangs-UND-NICHT-Glieder (60, 61), deren Ausgänge als seine Ausgänge dienen, deren eine Eingänge zusammengeschaltet sind und als Zähleingang (58) des Zählsignalschalters (56) auftreten, und einen Negator (59) enthält, dessen Aus- und Eingang an die anderen Eingänge des ersten und zweiten 2-Eingangs-UND-NICHT-Gliedes (60 bzw. 61) angeschlossen sind, wobei der andere Eingang des zweiten 2-Eingangs-UND-NICHT-Gliedes (61) als Eingang (57) zur Polaritätseinstellung des Zählsignalschalters (56) fungiert.

Geänderte Patentansprüche

1. (geändert) Kode-Impulsdauer-Wandler, der zwei Register (1,2), deren Schreibeingänge (3,4) an die Schiene (5) "Start" und deren Ausgänge ($6_1...6_n$, $7_1...$ $...7_p$) an die Kodeeingabeeingänge ($8_1...8_n$, $9_1...9_p$) eines Impulsdauer-Formers (10), in dem an den Ausgang eines Zählsignalschalters (22) der Zähleingang (23) eines Zählers (21) angeschlossen ist, dessen Überlaufausgang (34) an den Sperreingang (30) des Zählsignalschalters (22) gelegt ist, bzw. eines gesteuerten Frequenzteilers (12) geführt sind, und einen mit dem Eingang an die Schiene (5) "Start" gelegten Impulsgenerator (16) enthält, an den der Zähleingang (15) des gesteuerten Frequenzteilers (12) angeschlossen ist, dessen Ausgang (14) zum Zähleingang (13) des Impulsdauer-Formers (10) geführt ist, dessen Starteingang (11) an die Schiene (5) "Start" gelegt und dessen Ausgang (17) mit dem Ausgang des Kode-Impulsdauer-Wandlers elektrisch verbunden ist, **dadurch gekennzeichnet**, daß der Zähler (21) des Impulsdauer-Formers (10) reversierbar ausgeführt, der Zählsignalschalter (22) mit einem Eingang (33) zur Polaritätseinstellung und mit einem zusätzlichen Sperreingang (31) sowie mit einem Ausgang versehen ist, die jeweils an den Informationseingang ($36_n$) der höchstwertigen Stelle des Reversierzählers (21), an dessen anderen Überlaufausgang (35) und an dessen Zähleingang (24) geführt sind, und daß zusätzlich ein Ausgangssignalschalter (19) zur Verfügung steht, dessen Eingänge an die Ausgänge (17, 18) des Impulsdauer-Formers (10) und dessen Steuereingang (20) an den Aus-

gang ($6_n$) der höchstwertigen Stelle des einen Registers (1) gelegt sind und dessen Ausgänge (42, 43) als Ausgänge des Kode-Impulsdauer-Wandlers auftreten.

2. Wandler nach Anspruch 1, **dadurch gekennzeichnet**, daß der Zählsignalschalter (22) des Impulsdauer-Formers (10) vier 2-Eingangs-UND-NICHT-Glieder (25, 26, 27, 28), bei denen die einen Eingänge des ersten und zweiten Gliedes zusammengeschaltet sind und als Zähleingang (29) des Zählsignalschalters (22) dienen und die anderen Eingänge jeweils als Haupt-und zusätzlicher Sperreingang (30 bzw. 31) auftreten und die Ausgänge an die einen Eingänge des dritten und vierten 2-Eingang-UND-NICHT-Gliedes (27 bzw. 28) angeschlossen sind, deren Ausgänge als Haupt- und Zusatzausgang des Zählsignalschalters (22) dienen, und einen Negator (32) enthält, dessen Eingang mit dem anderen Eingang des dritten 2-Eingangs-UND-NICHT-Gliedes (27) verbunden ist und als Eingang (33) zur Polaritätseinstellung des Zählsignalschalters (22) dient und dessen Ausgang an den anderen Eingang des vierten 2-Eingangs-UND-NICHT-Gliedes (28) geführt ist.

3. Wandler nach den Ansprüchen 1,2, **dadurch gekennzeichnet**, daß der Ausgangssignalschalter (19) drei 2-Eingangs-UND-Glieder (38, 39, 40), wobei die Eingänge des ersteren von ihnen als dessen Eingänge dienen und der Ausgang an die einen Eingänge des zweiten und dritten 2-Eingangs-UND-Gliedes (39 bzw. 40) angeschlossen ist, deren Ausgänge als Ausgänge (42, 43) des Ausgangssignalschalters (19) dienen, und einen Negator (41) enthält, dessen Ausgang an den anderen Eingang des dritten 2-Eingangs-UND-Gliedes (40) gelegt und dessen Eingang mit dem anderen Eingang des zweiten 2-Eingangs-UND-Gliedes (39) verbunden ist.

FIG.1

**FIG.2**

EP 0 328 644 A1

FIG.3

# INTERNATIONAL SEARCH REPORT

International Application No PCT/SU 87/00093

**I. CLASSIFICATION OF SUBJECT MATTER** (if several classification symbols apply, indicate all) •

According to International Patent Classification (IPC) or to both National Classification and IPC

IPC$^4$  H03M 1/82

**II. FIELDS SEARCHED**

| Minimum Documentation Searched 7 | |
|---|---|
| Classification System | Classification Symbols |
| IPC$^4$ | H03M 1/00, 1/66, 1/82 |

Documentation Searched other than Minimum Documentation
to the Extent that such Documents are Included in the Fields Searched •

**III. DOCUMENTS CONSIDERED TO BE RELEVANT** •

| Category • | Citation of Document, 11 with indication, where appropriate, of the relevant passages 12 | Relevant to Claim No. 13 |
|---|---|---|
| A | WO, A1, 86/06896 (SONY CORPORATION) 20 December 1986 (20.12.86) see the abstract & JP, 61-51450 | 1,4 |
| A | SU, A1, 1064458 (SONY CORPORATION) 30 December 1983 (30.12.83) see the abstract | 1,4 |
| A | JP, B2, 61-51450 8 November 1986 (08.11.86) see the drawings | 1,4 |
| A | JP, B2, 61-51451 8 November 1986 (08.11.86) | 1,4 |
| A | JP, B2, 61-51452 8 November 1986 (08.11.86) | 1,4 |

---

\* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art.

"&" document member of the same patent family

**IV. CERTIFICATION**

| Date of the Actual Completion of the International Search | Date of Mailing of this International Search Report |
|---|---|
| 15 February 1988 (15.02.88) | 28 April 1988 (28.04.88) |
| International Searching Authority | Signature of Authorized Officer |
| ISA/SU | |

Form PCT/ISA/210 (second sheet) (January 1985)